# DEMANDE DE BREVET EUROPEEN

(11) **EP 1 326 335 A1**
(43) Date de publication de la demande: **09.07.2003**
(21) Numéro de dépôt: 02102779.2
(22) Date de dépôt: 17.12.2002
(51) Int. Cl.: H03H 11/36, H03F 3/72, H03K 17/693, H03K 17/00

(54) **Commutateur actif large bande à deux entrées et deux sorties à structure distribuée, et dispositif de controle de phase comportant un tel commutateur**

(30) Priorité: 18.12.2001 FR 0116394
(71) Demandeur: Thales, 75008 Paris (FR)
(72) Inventeur: DUEME, Philippi, 94117 CX, ARCUEIL (FR); GUERBEUR, Gilles, 94117 CX, ARCUEIL (FR)
(74) Mandataire: Lucas, Laurent Jacques

(57) **Abrégé**

La présente invention concerne un commutateur actif à deux entrées et deux sorties à structure distribuée. Le commutateur comporte deux parties (21, 22), chaque partie comportant un amplificateur distribué (41, 42) dont les cellules élémentaires comportent au moins deux transistors (Q₁ Q₂, Q'₁ Q'₂) montés en cascode, un transistor (Q₃, Q'₃) commandé via la ligne de grille (Lgc1) de l'amplificateur étant associé à chaque cellule, le transistor associé (Q₃) de la première partie (21) commandant l'état du transistor (Q'₁) en grille commune de la deuxième partie (22) et le transistor associé (Q'₃) de la deuxième partie (22) commandant l'état du transistor (Q₁) en grille commune de la première partie (21), les deux entrées (E₁, E₂) du commutateur étant les extrémités libres des lignes de grille (Ldc1) des deux amplificateurs distribués (41, 42) et les sorties (S₁, S₂) du commutateur étant les extrémités libres de ces deux amplificateurs. L'invention s'applique notamment aux dispositifs à contrôle de phase à commande numérique.

## Description

La présente invention concerne un commutateur actif à deux entrées et deux sorties à structure distribuée. L'invention s'applique notamment aux dispositifs à contrôle de phase à commande numérique. Ces derniers sont par exemple utilisés dans les domaines des télécommunications ou instrumentations hyperfréquence large bande. Ils sont aussi particulièrement utilisés dans des antennes de type balayage électronique. L'invention appartient notamment au domaine technique de la microélectronique hyperfréquence et plus particulièrement à la technologie des circuits intégrés monolithiques micro-ondes (MMIC).

Un dispositif de contrôle de phase à commande numérique fonctionne généralement sur la base d'une commutation entre au moins deux voies différentes, susceptibles chacune de se comporter soit comme un déphaseur, soit comme une ligne à longueur programmable. En pratique dans un déphaseur, entre deux états, le signal subit en transmission un déphasage dont la valeur est constante dans la bande de fréquences considérée. Au contraire dans une ligne de longueur programmable, entre deux états, le signal subit en transmission un déphasage dont la valeur correspond à la propagation du courant le long d'une ligne de longueur constante (c'est-à-dire un retard constant) dans la bande de fréquence considérée.

De façon connue un dispositif de contrôle de phase comprend une entrée de commande numérique et, entre une entrée de signal et une sortie de signal, au moins une cellule comportant des moyens de commutation passifs aptes, sous contrôle d'un bit de l'entrée de commande, à procurer au moins deux fonctions de transfert différentes en termes de phase et/ou retard temporel. On sait mettre en oeuvre un tel dispositif de contrôle de phase à partir d'une technologie de circuits intégrés monolithiques micro-onde (MMIC) sur une bande de fréquences allant par exemple de 2 à 18 GHz. Cependant, la mise en série de plusieurs cellules réalisées entièrement en technologie MMIC conduit à des pertes d'insertion relativement importantes. En effet, un commutateur passif fonctionnant dans la bande de fréquences allant par exemple jusqu'à plusieurs dizaines de GHz est susceptible de perdre en insertion 1 à 2 dB selon l'isolement.

De même une cellule de déphase ou de retard peut présenter des pertes allant jusqu'à 2 dB pour les bits de poids moyens et forts. Ainsi, la réalisation en technologie MMIC d'une ligne à longueur programmable de 9 bits comprenant 9 cellules de même structure mises en série peut conduire à des pertes d'insertion comprises entre 30 et 40 dB.

Ce problème de pertes d'insertion peut être résolu par l'utilisation de commutateurs actifs à structure distribuée tels que décrits dans la demande de brevet français 98 16556. Ces commutateurs actifs présentent notamment l'avantage de combiner la fonction amplification et la fonction commutation en s'affranchissant des pertes d'un commutateur passif. Ces commutateurs actifs sont soit des commutateurs à deux entrées et une sortie, soit des commutateurs à une entrée et deux sorties.

Un but de l'invention est notamment de permettre la réalisation de commutateurs actifs à deux entrées et deux sorties. A cet effet, l'invention a pour objet un commutateur actif comportant deux double-amplificateur distribués. Chaque double amplificateur comporte un amplificateur supérieur et un amplificateur inférieur ayant chacun une ligne de drain et une ligne de grille qui leur est commune, l'entrée E₁, E₂ d'un amplificateur étant l'extrémité libre de sa ligne de grille et sa sortie étant l'extrémité libre de sa ligne de drain, les entrées des amplificateurs formant les deux entrées E₁, E₂ du commutateur, les sorties des deux amplificateurs supérieurs étant reliées pour former la première sortie S₁ du commutateur, les sorties des deux amplificateurs inférieurs étant reliées pour former la deuxième sortie S₂ du commutateur, l'aiguillage d'un signal d'une entrée vers une sortie étant commandé par l'état des amplificateurs.

Dans un autre mode de réalisation, un commutateur selon l'invention comporte deux parties, chaque partie comportant un amplificateur distribué dont les cellules élémentaires comportent au moins deux transistors montés en cascode. On commande l'état de chaque transistor en source commune en appliquant la tension de commande sur sa grille. Le signal issu d'un des transistors en source commune (celui commuté en passant) est alors dirigé vers le transistor en grille commune qui est commun aux deux transistors en source commune dans une structure cascode partagée. Les deux entrées E₁, E₂ du commutateur étant les extrémités libres des lignes de grille des deux amplificateurs distribués et les sorties S₁, S₂ du commutateur étant les extrémités libres de ces deux amplificateurs.

L'invention a également pour objet un dispositif de contrôle de phase comportant un tel commutateur.

L'invention a pour principaux avantages qu'elle permet la réalisation d'un commutateur actif à deux entrées et deux sorties à la fois compacte et économique.

D'autres caractéristiques et avantages de l'invention apparaîtront à l'aide de la description qui suit faite en regard de dessins annexés qui représentent :
- la figure 1, un exemple de réalisation de dispositif de contrôle de phase comportant des cellules de déphasage à deux voies séparées par des commutateurs ;
- la figure 2, un premier exemple de réalisation d'un commutateur actif selon l'invention ;
- la figure 3, un simple amplificateur distribué comprenant n cellules amplificatrices ;
- la figure 4, une illustration par un schéma de principe, d'un deuxième exemple de réalisation d'un commutateur actif selon l'invention ;
- la figure 5, un détail des connexions des éléments actifs composant le commutateur précédent.

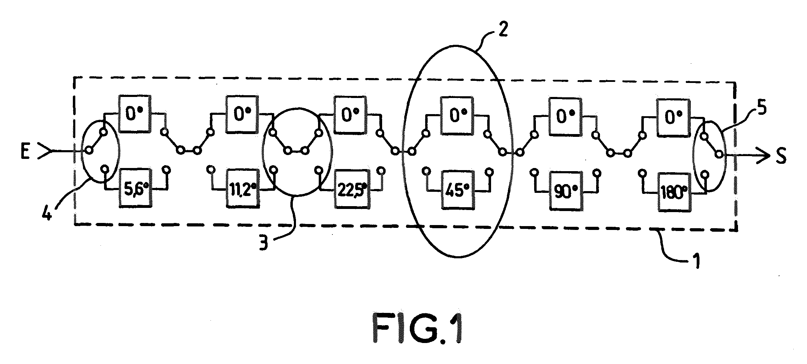

La figure 1 présente un exemple de déphaseur 1 à six bits de commande, c'est-à-dire qu'il comporte six cellules de déphasage 2. Chaque cellule comporte deux voies effectuant deux déphasages différents. Chaque cellule comporte ainsi une voie de déphasage ϕ et une voie effectuant un déphasage élémentaire de ϕ + 360°/2ⁿ où n est le rang du bit de commande associé à la cellule. A titre d'exemple, on peut considérer que ϕ = 0. A l'entrée de chaque cellule, le signal est commuté dans l'une et l'autre voie selon le déphasage élémentaire que doit lui appliquer la cellule. Dans l'exemple de la figure 1, on peut ainsi réaliser un déphasage parmi tous les déphasages compris entre 0° et 360° par pas de 5,625°. Un commutateur 3 est placé entre deux cellules consécutives, il s'agit d'un commutateur à deux entrées et deux sorties. Un commutateur 4, à une voie d'entrée et deux voies de sortie, commute le signal d'entrée E vers l'une ou l'autre voie de la première cellule de déphasage. Un commutateur 5, à deux entrées et une sortie, commute l'une ou l'autre voie de la dernière cellule vers la sortie S du déphaseur.

Il a été indiqué précédemment que des commutateurs passifs provoquent des pertes d'insertion non négligeables. La demande de brevet français 98 16556 divulgue un commutateur actif, ayant par ailleurs une fonction d'amplification, qui permet de s'affranchir de ces pertes. Ce commutateur actif comporte soit une entrée et deux sorties, soit deux entrées et une sortie.

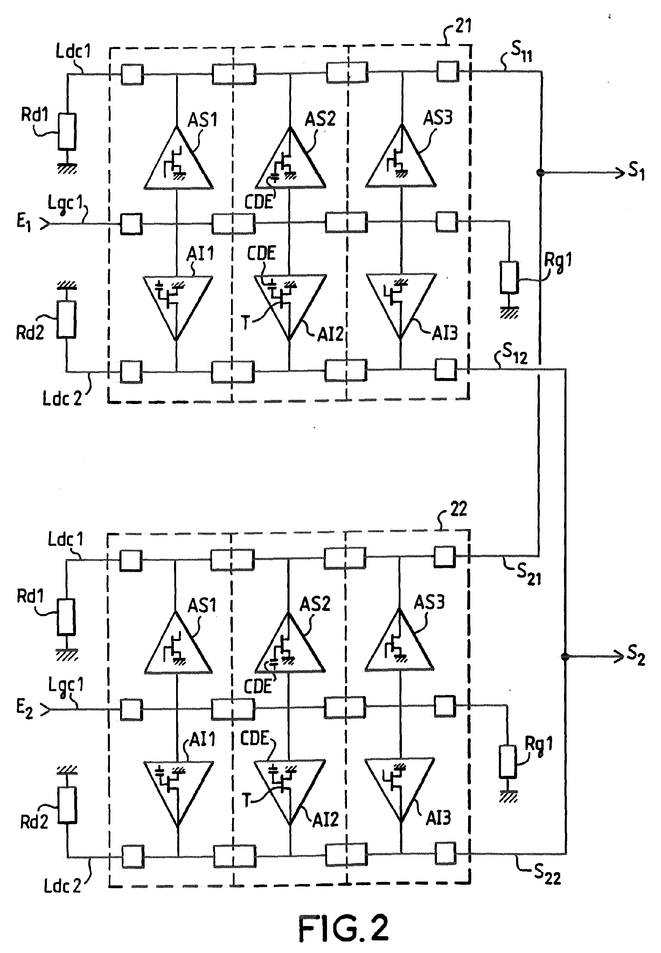

La figure 2 présente un premier exemple de réalisation d'un commutateur actif selon l'invention, commutateur ayant deux entrées et deux sorties. Un tel commutateur comporte deux parties identiques 21, 22 ayant même structure. Plus précisément, chaque partie a une structure distribuée formant un commutateur actif à une entrée et deux sorties du type de ceux décrits dans la demande de brevet français 98 16556. Ce commutateur 21, 22 est réalisé sur le principe d'un double amplificateur distribué, comportant deux amplificateurs distribués, un amplificateur supérieur et un amplificateur inférieur.

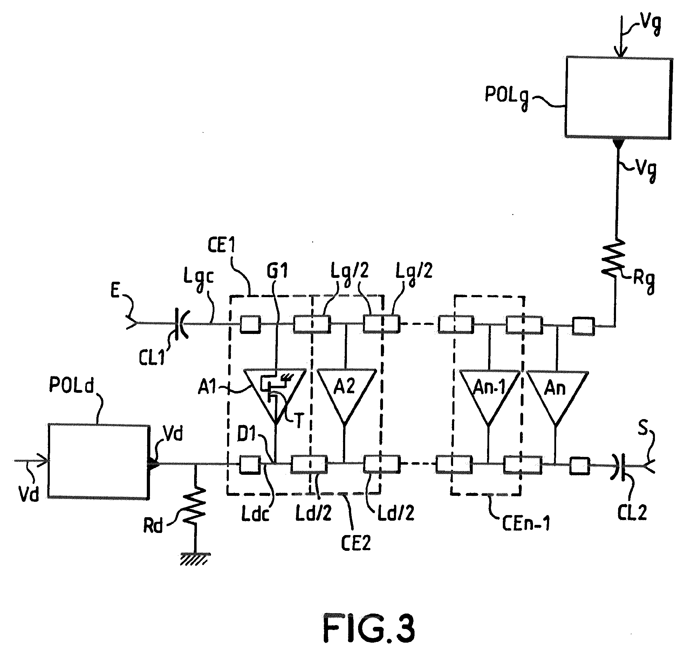

La figure 3 présente un simple amplificateur distribué comprenant n cellules amplificatrices CE à base de transistors.

Pour simplifier la description, seuls les modes de réalisation à base de transistors à effet de champs montés en source commune sont ici décrits, mais il est possible d'utiliser d'autres types de transistors, par exemple bipolaires à hétéro jonction ou analogues.

Les cellules amplificatrices sont montées entre une ligne de grille commune Lgc à laquelle sont connectées toutes les grilles des transistors des cellules amplificatrices et une ligne de drain commune Ldc où convergent les drains des transistors des cellules amplificatrices CE.

Chaque cellule amplificatrice comporte une structure amplificatrice A représentée sous la forme d'un triangle et constituée chacune d'un ou plusieurs transistors T montés en source commune ou en configuration « cascode» par exemple. La grille du transistor est reliée à un point de la ligne de grille commune Lgc qui s'étend entre un point d'entrée du montage E et une résistance Rg reliée à la masse. Le drain du transistor est relié à un point de la ligne de drains commune Ldc qui s'étend entre une résistance Rd reliée à la masse et un point de sortie S du montage.

Les points de liaison des transistors sur la ligne de drains commune se succèdent sur ladite ligne de drains commune Ldc, dans le même ordre que les points de liaison desdits transistors, sur la ligne de grilles commune Lgc.

Chaque cellule amplificatrice est complétée par des éléments passifs, notamment des inductances, servant à constituer des équivalents de tronçons de la ligne de drains et de la ligne de grilles. Par exemple, la cellule CE2 comprend un tronçon formé de Lg/2 et d'un condensateur Cgs et un tronçon formé de Ld/2 et d'un condensateur Cds.

La tête de la ligne de grilles commune Lgc forme l'entrée E de l'amplificateur distribué. L'autre extrémité de la ligne de grilles commune Lgc est chargée sur une résistance terminale Rg qui est sensiblement égale à l'impédance caractéristique Zg de la ligne de grilles commune Lgc. Le plus souvent, la résistance terminale Rg est de 50 ohms.

De même, l'une des extrémités de la ligne de drains commune Ldc est chargée sur une résistance terminale Rd sensiblement égale à l'impédance caractéristique Zd de la ligne de drains commune Ldc, tandis que l'autre extrémité de la ligne de drains commune définit la sortie S de l'amplificateur distribué.

Des moyens de polarisation POLg appliquent une tension de polarisation continue Vg à la ligne de grilles commune Lgc par exemple à travers la résistance Rg.

De même, des moyens de polarisation POLd appliquent une tension de polarisation continue Vd à la ligne de drains commune Ldc.

Les moyens de polarisation POLd ou POLg peuvent être de différents types, notamment une inductance de forte valeur ou bien une résistance ou encore des charges saturables distribuées ou non.

Des capacités de liaisons CL1 et CL2 sont prévues respectivement entre l'entrée E et la tête de la ligne de grilles commune Lgc, et entre l'extrémité de la ligne de drains commune Ldc et la sortie S de l'amplificateur distribué.

Le fonctionnement d'un amplificateur distribué du type de celui illustré sur la figure 3 est le suivant.

Le signal d'entrée appliqué en entrée E se propage sur la ligne de grilles commune Lgc pour être absorbé par la charge Rg. Sur chaque grille de transistors passe donc une onde de tension, se propageant de la gauche vers la droite, sur la figure 3. Un courant est alors généré par chaque transistor. Il alimente la ligne de drains commune Ldc. Ce courant se propage pour partie vers la charge Rd et pour partie vers la sortie S. Les composantes qui vont vers la sortie S se superposent avec la même phase, pourvu que le temps de propagation inter cellule soit identique sur la ligne de drains commune et sur la ligne de grilles commune. L'amplification est à très large bande passante, car elle commence depuis le continu jusqu'aux fréquences de coupure des filtres LC réalisées par les lignes de grilles et de drains avec les capacités parasites des transistors. Ces fréquences de coupure peuvent être très hautes, de plusieurs dizaines de GHz, à la centaine de GHz, avec des conceptions appropriées.

Un commutateur actif à une entrée et deux sorties est donc réalisé sur le principe d'un double amplificateur distribué.

En référence à la figure 2, un double amplificateur distribué 21, 22 comprend donc une ligne de grilles commune Lgc1 et deux lignes de drains communes Ldc1 et Ldc2 pour réaliser un commutateur actif à une entrée et deux sorties. Le premier double amplificateur 21 comporte ainsi une entrée E₁ et deux sorties S₁₁, S₁₂. L'entrée E₁ est commune aux deux amplificateurs, cette entrée est l'extrémité libre de la ligne de grille, c'est-à-dire l'extrémité non reliée par exemple au potentiel de masse via une résistance de terminaison Rg1. Les sorties S₁₁, S₁₂ sont les sorties des amplificateurs. La sortie S₁₁, S₁₂ d'un amplificateur est l'extrémité libre de sa ligne de drain, c'est-à-dire l'extrémité non reliée par exemple au potentiel de masse via une résistance de terminaison Rd1, Rd2. Le deuxième double amplificateur 22 comporte quant à lui une entrée E₂ et deux sorties S₂₁ et S₂₂ définies de la même façon. Les entrées E₁, E₂ constituent les entrées du commutateur à deux entrées.

Pour un double amplificateur 21, 22, la ligne centrale est la ligne de grilles commune Lgc1. Les lignes inférieures et supérieures sont les lignes de drains communes Ldc1 et Ldc2.

Des moyens de polarisation (non représentés) sont prévus pour commander les transistors T des structures amplificatrices supérieures AS (individualisées en AS1 à AS3) et inférieures Al (individualisées en Al1 à Al3), soit en mode amplificateur, soit en mode bloqué.

Par exemple, les moyens de polarisation sont similaires à ceux décrits en référence à la figure 3.

En pratique, la commande de commutation entre le mode bloqué et le mode amplificateur, est appliquée sur les grilles des transistors T des structures amplificatrices supérieures AS et inférieures Al. On peut aussi appliquer la commande de commutation sur les drains mais cette solution est plus complexe en raison du courant de drain qui pénalise la rapidité de la commande. Une capacité CDE peut être reliée en série avec la capacité de la grille Cgs d'un transistor T pour former un pont capacitif.

Comme il a été indiqué précédemment, les deux entrées d'un commutateur selon la figure 2 sont les entrées E₁, E₂ respectivement du premier double amplificateur 21 et du deuxième double amplificateur 22. Pour obtenir les deux sorties S₁, S₂ les sorties des double-amplificateur 21, 22 sont reliées deux à deux de manière croisée. Ainsi, la sortie S₁₁ du premier double amplificateur 21, issue de la ligne de drain commune Ldc1 supérieure, est reliée à la sortie S₂₁ du deuxième amplificateur 22 issue de sa ligne de drain commune Ldc1 supérieure, pour former une première sortie S₁. De même, la sortie S₁₂ du premier double amplificateur 21, issue de la ligne de drain commune Ldc2 inférieure, est reliée à la sortie S₂₂ du deuxième amplificateur 22 issue de sa ligne de drain commune Ldc2 inférieure, pour former la deuxième sortie S₂.

Il y a en fait quatre rangées de structures amplificatrices. Le plus souvent une seule est en mode amplification, les trois autres étant bloquées. On peut aussi envisager des modes « doubles » avec la même structure en polarisant deux rangées en même temps. On peut ainsi relier l'entrée E₁ aux sorties S₁ et S₂, ou relier l'entrée E₂ aux sorties S₁ et S₂. Dans ces deux cas on réalise un diviseur commuté, un signal qui entre en E₁ (ou E₂) étant divisé entre S₁ et S₂. On peut aussi relier les deux entrées E₁ et E₂ à la sortie S₁, ou relier les deux entrées E₁ et E₂ à la sortie S₂. Dans ces deux derniers cas on réalise un combineur commuté, deux signaux arrivant sur E₁ et E₂ se combinant à la sortie S₁ (ou S₂).

Le fonctionnement d'un double amplificateur distribué 21, 22 du type dans lequel les transistors T des structures amplificatrices supérieures AS sont polarisés dans un état bloqué tandis que les transistors T des structures amplificatrices inférieures Al sont polarisés dans un état amplificateur, est le suivant, par exemple pour le premier double amplificateur 21.

Le signal d'entrée appliqué en entrée E₁ se propage sur la ligne de grilles commune Lgc1 pour être absorbé par la charge Rg1. Sur chaque grille de transistors de chaque structure amplificatrice inférieure passe donc une onde de tension, se propageant de la gauche vers la droite, sur la figure 2. Un courant est alors généré par chaque transistor de chaque structure amplificatrice inférieure. Ce courant ainsi généré alimente la ligne de drains commune Ldc2. Ce courant se propage pour partie vers la charge Rd2 et pour partie vers la sortie S₁₂. Les composantes qui vont vers la sortie S₁₂ se superposent avec la même phase, pourvu que le temps de propagation inter cellule soit identique sur la ligne de drains commune Ldc2 et sur la ligne de grilles Lgc1. L'amplification est alors la combinaison des amplifications réalisées par chaque transistor de chaque structure amplificatrice inférieure. Aucun courant ne se propage sur la ligne de drains commune Ldc1 dans la mesure où les transistors des structures amplificatrices supérieures sont polarisés en mode bloqué.

De même, en commutant la polarisation des structures amplificatrices inférieures et supérieures respectivement en mode bloqué et en mode amplificateur, on obtient un courant qui se propage vers la sortie S₁₁ et aucun courant vers la sortie S₁₂.

Enfin, lorsque les transistors des structures supérieures et inférieures sont tous à l'état bloqué, un signal présent en entrée E₁ n'est transféré vers aucune des sorties S₁₁, S₁₂.

L'aiguillage d'un signal d'une entrée E₁, E₂ vers une sortie S₁, S₂ du commutateur est donc commandée par l'état des amplificateurs, en mode passant ou bloqué. La commande d'un amplificateur à l'état passant, les autres étant commandés à l'état bloqué aiguille l'entrée de cet amplificateur vers sa sortie. Par exemple, la commande de l'amplificateur supérieur du premier double amplificateur 21 à l'état passant, les autres étant bloqués, aiguille un signal de l'entrée E₁ vers la sortie S₁.

Le commutateur peut alors être commandé à partir de deux bits de commande. L'état du premier bit commande par exemple le blocage de tous les transistors des double-amplificateur, c'est-à-dire détermine si c'est l'entrée E₁ ou l'entrée E₂ qui est commutée. Le deuxième bit commande l'état des transistors supérieurs et inférieurs, c'est-à-dire que selon sa valeur ce sont les transistors supérieurs qui sont bloqués et les transistors inférieurs passant, et vice versa. Ce deuxième bit détermine alors l'aiguillage vers la sortie S₁ ou la sortie S₂. Des circuits d'interface connus permettent de relier l'état de ces deux bits de commande à la polarisation des transistors. En fait, les valeurs des deux bits doivent être converties en quatre tensions de commande V_{g1,} V_{g2,} V_{g3,} V_{g4}, une de ces tensions étant portée à une valeur commandant les transistors associés à l'état amplificateur, les trois autres tensions étant à une valeur bloquant les transistors associés. Chaque tension va commander une rangée de transistors par leurs grilles. Il est bien sûr possible de commander deux rangées à la fois pour réaliser des diviseurs commutés ou des combineurs commutés tels que décrits précédemment.

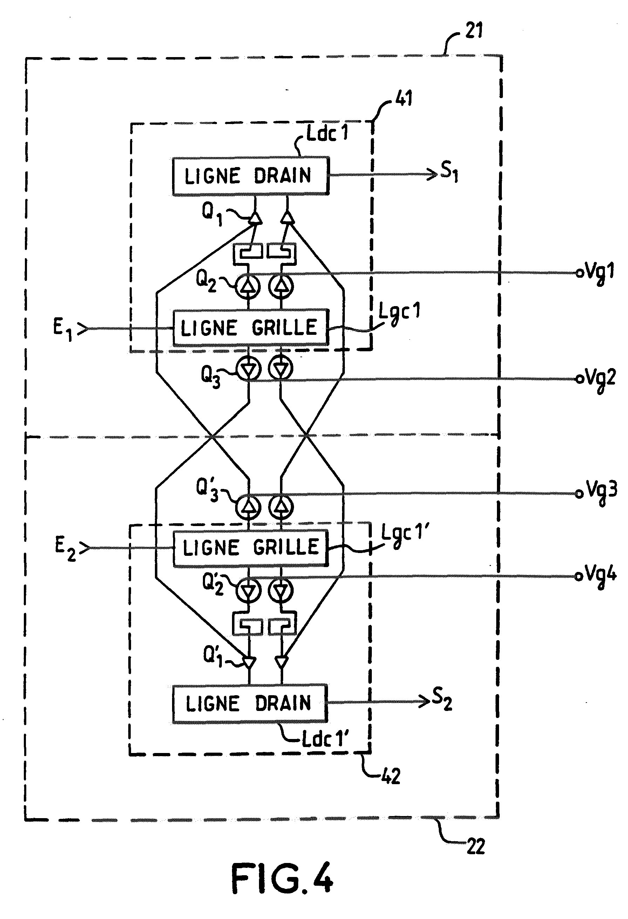

La figure 4 illustre par un schéma de principe un autre mode de réalisation possible d'un commutateur selon l'invention. Comme le montre le schéma de principe, le commutateur comporte toujours deux parties 21, 22, mais dans ce mode de réalisation, chaque partie ne forme plus un double amplificateur comme dans le mode de réalisation précédent. Chaque partie comporte un amplificateur distribué 41, 42 du type de la figure 3 où chacune de ses cellules comporte par exemple au moins deux transistors Q₁, Q₂ montés en cascode formant amplificateur. Par ailleurs chaque partie comporte pour chaque paire de transistors Q₁, Q₂ au moins un transistor Q₃ en source commune commandé via la ligne de grille Lgc1 de l'amplificateur. Les états des transistors Q₂, Q₃, Q'₂, Q'₃ sont commandés par les tensions V_{g1,} V_{g2,} V_{g3,} V_{g4} précitées.

Dans ce mode de réalisation les connexions croisées ne se font plus au niveau des sorties, mais au niveau des liaisons entre les transistors de chaque cellule cascode. Cela permet notamment de n'avoir qu'un transistor en grille commune Q₁ pour deux transistors Q₂, Q₃ en source commune qui servent de commutateurs par la commande qui applique sur leur grille et ainsi de limiter à deux le nombre total de lignes de drain, ce qui permet donc de réaliser un circuit plus compact. Selon que le transistor Q₂ ou que le transistor Q₃ est commandé à l'état passant, un signal présent en entrée E₁ de l'amplificateur 41 est orienté vers la sortie S₁ de l'amplificateur ou vers la sortie S₂ de l'autre amplificateur 42, du fait des connexions croisées. Cette connexion croisée est en effet telle que le transistor en grille commune Q'₁ de la deuxième partie 22 forme, soit avec le transistor Q'₂ de la deuxième partie 22, soit avec le transistor Q₃ de la première partie 21, un montage en cascode, selon que Q'₂ ou Q₃ est commandé à l'état amplificateur. De même, cette connexion croisée est telle que le transistor en grille commune Q₁ de la première partie 21 forme, soit avec le transistor Q₂ de la première partie 21, soit avec le transistor Q'₃ de la deuxième partie 22, un montage en cascode, selon que Q₂ ou Q'₃ est commandé à l'état amplificateur. Pour faciliter la description, les transistors de la première partie 21 sont notés Q₁, Q₂, Q₃ et les transistors de la deuxième partie 22 sont notés Q'₁, Q'₂, Q'₃.

Les deux entrées du commutateur sont les entrées E₁, E₂ des deux amplificateurs distribués 41, 42, au niveau de leurs lignes de grille Lgc1, c'est-à-dire les extrémités libres des lignes de grille, non reliées par exemple à un potentiel de masse. Les deux sorties S₁, S₂ du commutateur sont les sorties de ces deux amplificateurs distribués, au niveau de leurs lignes de drain Ldc1, c'est-à-dire les extrémités libres des lignes drain, non reliées par exemple à un potentiel de masse.

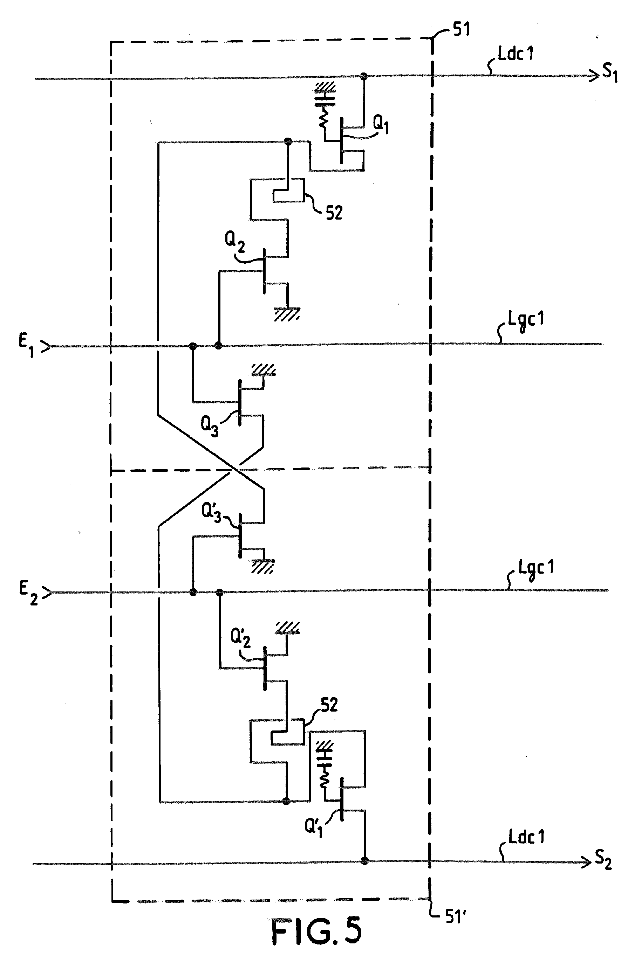

La figure 5 montre les connexions des éléments actifs, en particulier des transistors, les éléments passifs n'étant pas représentés. Une seule cellule 51, 51' a par ailleurs été représentée pour chacune des deux parties 21, 22 du commutateur. Les connexions de la cellule 51 de la première partie sont croisées avec les connexions de la cellule 51' de la deuxième partie. Une cellule 51 comporte une cellule élémentaire à au moins deux transistors en cascode Q₁, Q₂ et son transistor Q₃ associé. Ainsi, pour la cellule de la première partie 21 le drain du transistor Q₁ est relié à la ligne de drain Ldc1 et sa source est reliée au drain du transistor Q₂ dont la grille est reliée à la ligne de grille Lgc1. La grille du transistor Q'₃ est reliée à la ligne de grille Lgc1 de l'autre cellule 51'. Le drain de ce transistor Q'₃ est aussi relié à la source du transistor Q₁. Par symétrie, les connexions sont identiques en ce qui concerne l'autre partie 22. En particulier, le drain du transistor Q₃ est relié à la source du transistor Q'₁ de la deuxième partie 22. Tous les transistors ont leur source reliée à un potentiel de référence, par exemple le potentiel de masse. Pour pallier une dissymétrie du circuit, une longueur de ligne 52 est intercalée entre la source du transistor Q₁ et le drain du transistor Q₂. De même, une longueur de ligne est intercalée entre la source du transistor Q'₁ et le drain du transistor Q'₂. Cette longueur de ligne est par exemple formée d'une spirale 52. Cette dernière permet notamment de compenser la différence de distance entre les transistors Q₁ et Q₂ d'une part et Q₁ et Q'₃ d'autre part. Le commutateur fonctionne comme indiqué par la suite.

Les entrées des première et deuxième parties, au niveau des lignes de grille, constituent respectivement l'entrée E₁ et l'entrée E₂ du commutateur. De même, les sorties des première et deuxième parties, au niveau des lignes de drain, constituent respectivement la sortie S₁ et la sortie S₂ du commutateur. Le circuit fonctionne alors dans l'un des quatre états suivant, choisi en appliquant les tensions adéquates sur les grilles des transistors Q₂, Q'₂, Q₃, Q'₃.

Le transistor Q₂ est commandé, les autres transistors Q'₂, Q₃, Q'₃ étant bloqués, l'entrée E₁ est reliée à la sortie S₁ via les transistors Q₁, Q₂ qui forment une structure cascode active et amplifient par ailleurs le signal.

Le transistor Q'₃ est commandé, l'entrée E₂ est reliée à la sortie S₁ via les transistors Q₁, Q'₃ passant et amplifiant par ailleurs le signal.

Le transistor Q'₂ est commandé, l'entrée E₂ est reliée à la sortie S₂ via les transistors Q'₁, Q'₂ passant et amplifiant par ailleurs le signal.

Le transistor Q₃ est commandé, l'entrée E₁ est reliée à la sortie S₂ via les transistors Q'₁, Q₃ passant et amplifiant par ailleurs le signal.

Chaque transistor peut être remplacé par un ensemble de transistors montés en cascode.

Les transistors sont par exemple des montages de transistors élémentaires assemblés en cascode.

L'invention concerne également un dispositif de contrôle de phase constitué d'une chaîne de cellules de déphasage à deux voies séparées par des commutateurs. Un ou plusieurs de ces commutateurs étant des commutateurs actifs tels que définis par l'un des modes de réalisation précédents. En particulier le dispositif de contrôle de phase peut par exemple avoir une structure du type de celui présenté par la figure 1. Dans un premier mode de réalisation, tous les commutateurs 3 sont par exemple actifs. Dans un autre mode de réalisation, les commutateurs ne sont pas tous actifs, certains étant passifs. Avantageusement, les commutateurs de la chaîne sont ainsi par exemple alternativement actif et passif. En particulier, cette solution d'alternance permet notamment d'atteindre un bon compromis entre les performances de l'ensemble du déphaseur et surface occupée par cet ensemble. Il a été indiqué précédemment que l'emploi de commutateurs actifs permettait de compenser notamment des pertes d'insertion. L'emploi de seuls commutateurs actifs dans la chaîne du dispositif de contrôle de phase peut néanmoins apporter certains inconvénients. Cet inconvénient est qu'ils amplifient de façon excessive un signal qui les traverse. A l'issue du passage du signal dans plusieurs commutateurs actifs, ce dernier est alors fortement amplifié. Il faut alors prévoir un dimensionnement des composants, des commutateurs eux-mêmes mais aussi des déphaseurs élémentaires 2, qui supportent cette augmentation de puissance ainsi produite. Une conséquence directe de dimensionnement est notamment l'augmentation de surface occupée par ces composants, ce qui va à l'encontre d'un objectif de réduction de l'encombrement des déphaseurs, mais aussi de réduction de coût et bien sûr de consommation. La solution d'alternance actif-passif permet de répondre à cet objectif. A partir de l'entrée E du déphaseur où un signal comporte une puissance initiale P₀, sa puissance augmente dans le premier commutateur, qui est par exemple actif, jusqu'à une puissance P₁. Sa puissance diminue ensuite dans le deuxième commutateur, qui est alors passif, puis augmente de nouveau dans le commutateur actif suivant et ainsi de suite. Il en résulte que tout au long de la chaîne et jusqu'à la sortie, la puissance qui traverse les différents composants n'excède pas ou peu la puissance P₁, et reste donc en deçà d'une limite admissible. Il est bien sûr possible de réaliser une alternance passif - actif - passif en plaçant un commutateur passif en entrée du dispositif de contrôle de phase. Les commutateurs d'entrée 4 et de sortie 5, s'ils sont actifs, sont par exemple de ceux décrits dans la demande de brevet français n° 98 16556. On peut également utiliser toute autre combinaison qu'une alternance stricte entre commutateurs actifs et passifs, par exemple deux actifs pour un passif ou l'inverse, selon notamment les compromis à réaliser.

## Revendications

1. Commutateur actif, **caractérisé en ce qu'**il comporte deux double amplificateur distribués (21, 22), chaque double amplificateur ayant un amplificateur supérieur et un amplificateur inférieur ayant chacun une ligne de drain (Ldc1, Ldc2) et une ligne de grille (Lgc1) qui leur est commune, l'entrée (E₁, E₂) d'un amplificateur étant l'extrémité libre de sa ligne de grille (Lgc1) et sa sortie (S₁₁, S₂₁, S₁₂, S₂₂) étant l'extrémité libre de sa ligne de drain, les entrées des amplificateurs formant les deux entrées (E₁, E₂) du commutateur, les sorties (S₁₁, S₂₁) des deux amplificateurs supérieurs étant reliées pour former la première sortie (S₁) du commutateur, les sorties (S₁₂, S₂₂) des deux amplificateurs inférieurs étant reliées pour former la deuxième sortie (S₂) du commutateur, l'aiguillage d'un signal d'une entrée vers une sortie étant commandé par l'état des amplificateurs.

2. Commutateur actif, **caractérisé en ce qu'**il comporte deux parties (21, 22), chaque partie comportant un amplificateur distribué (41, 42) dont les cellules élémentaires comportent au moins deux transistors Q₁ Q₂, Q'₁ Q'₂ montés en cascode, un transistor Q₃, Q'₃ commandé via la ligne de grille (Lgc1) de l'amplificateur étant associé à chaque cellule, que le transistor en grille commune Q'₁ de la deuxième partie (22) formant, soit avec le transistor Q'₂ de la deuxième partie (22), soit avec le transistor Q₃ de la première partie (21), un montage en cascode, selon que Q'₂ ou Q₃ est commandé à l'état amplificateur, le transistor en grille commune Q₁ de la première partie (21) formant, soit avec le transistor Q₂ de la première partie (21), soit avec le transistor Q'₃ de la deuxième partie (22), un montage en cascode, selon que Q₂ ou Q'₃ est commandé à l'état amplificateur, les deux entrées (E₁, E₂) du commutateur étant les extrémités libres des lignes de grille (Ldc1) des deux amplificateurs distribués (41, 42) et les sorties (S₁, S₂) du commutateur étant les extrémités libres de ces deux amplificateurs.

3. Commutateur selon la revendication 2, **caractérisé en ce que** la première partie (21) comportant au moins une cellule (51) ayant au moins deux transistors Q₁, Q₂ montés en cascode et un transistor associé Q₃, la deuxième partie (21) comportant au moins une cellule (51') ayant au moins deux transistors Q'₁, Q'₂ montés en cascode et un transistor associé Q'₃, les connexions des deux cellules sont croisées de sorte que le drain du transistor Q₁ est relié à la ligne de drain Ldc1 de son amplificateur distribué (41) et sa source est reliée au drain du transistor Q₂ dont la grille est reliée à la ligne de grille Lgc1, la grille du transistor Q'₃ étant reliée à la ligne de grille Lgc1 de l'autre cellule (51'), le drain de ce transistor Q'₃ étant relié à la source du transistor Q₁, et que le drain du transistor Q'₁ est relié à la ligne de drain Ldc1 de son amplificateur distribué (42) et sa source est reliée au drain du transistor Q'₂ dont la grille est reliée à la ligne de grille Lgc1, la grille du transistor Q₃ étant reliée à la ligne de grille de l'autre cellule (51'), le drain de ce transistor Q₃ étant relié à la source du transistor Q'₁.

4. Commutateur selon la revendication 3, **caractérisé en ce qu'**une longueur de ligne (52) est intercalée entre la source du transistor Q₁ et le drain du transistor Q₂ et entre la source du transistor Q'₁ et le drain du transistor Q'₂.

5. Commutateur selon la revendication 4, **caractérisé en ce que** la longueur de ligne (52) est formée d'une spirale.

6. Commutateur selon l'une quelconque des revendications 2 à 5, **caractérisé en ce que** les transistors sont des montages de transistors élémentaires en cascode.

7. Dispositif à contrôle de phase comportant des cellules ayant deux voies effectuant deux déphasages différents, un commutateur à deux entrées et deux sorties étant placé entre deux cellules consécutives, **caractérisé en ce qu'**il comporte au moins un commutateur actif selon l'une quelconque des revendications précédentes.

8. Dispositif selon la revendication 7, **caractérisé en ce que** les commutateurs sont alternativement actifs et passifs.
